Europäisches Patentamt

European Patent Office

Office européen des brevets

(19)

(11) Publication number: **0 251 490**
**A2**

## (12) EUROPEAN PATENT APPLICATION

(21) Application number: **87304705.4**

(22) Date of filing: **27.05.87**

(51) Int. Cl.4: **C09J 5/02**

(30) Priority: **26.06.86 GB 8615605**

(43) Date of publication of application:
**07.01.88 Bulletin 88/01**

(84) Designated Contracting States:
**AT BE CH DE ES FR GB GR IT LI LU NL SE**

(71) Applicant: **IMPERIAL CHEMICAL INDUSTRIES PLC**
**Imperial Chemical House Millbank**
**London SW1P 3JF(GB)**

(72) Inventor: **Lawson,John Robert**
**14 West Street**
**Middleton Manchester M24 3BE(GB)**

(74) Representative: **James, David Gomer et al**
**Imperial Chemical Industries PLC Legal**
**Department: Patents Po Box 6 Bessemer**
**Road**
**Welwyn Garden City Herts, AL7 1HD(GB)**

(54) **Metal-polymer adhesion.**

(57) Copper to substrate bonding using low functionality (B-staged) adhesives is improved by application of a highly functionalised primer coat after treatment of the metal surface with an adhesion promoter. The adhesive, primer coat and adhesion promoter are preferably mutually compatible. The adhesive is an acrylic adhesive and the primer coat and adhesion promoter both contain groups which are compatible with an acrylic group.

EP 0 251 490 A2

## METAL-POLYMER ADHESION

The present invention relates to a new method of improving the adhesion strength of metals to various substrates by means of polymer-based adhesives. More particularly the invention is directed to a method of increasing bonding of metal to metal and metal to organic compounds such as polymers, by the use of polymer-based adhesives.

It is desirable for many purposes, for example the manufacture of composite articles, or the production of printed circuit boards, to first coat a metal surface of for example a copper article with an adhesive organic compound, particularly a polymeric material such as an acrylic or epoxy adhesive.

Improved adhesion of metal to metal or metal to a substrate can be obtained by increasing the surface area of the metal by chemical or physical methods. Alternatively the metal surfaces, for example a copper surface, may be treated with a proprietary chemical prior to application of the adhesive. Such proprietary chemicals, which are used to give improved adhesion, are called adhesion promoters. One particularly efficient adhesion promoter for bonding of copper substrates is 5(6)-(6-(meth)acryloylamidohexanoyl)-aminobenzotriazole, which is disclosed in United States Patent 3837964. 5-(4-di(beta-acryloyl-aminoethyl)-aminophenylazo)benzotriazole, which is also disclosed in the latter patent, is another material which is suitable for use as an adhesion promoter. The adhesion promoters are often applied on the metal surface by immersion of the metal in a solution of the adhesion promoter, for example in an alcoholic solution, and subsequent drying of the coated metal surface to remove the solvent.

We have found that the full potential of the adhesion promoter is not realised when metal or metal oxide surfaces such as copper surfaces are pretreated with an adhesion promoter and bonded to a substrate using a partially pre-polymerised adhesive. We have found that satisfactory bonding is achieved only when using highly functionalised, low molecular weight (before curing) adhesives, for example low molecular weight acrylic adhesives. However, for certain applications, such as in the primary fabrication of copper laminates for printed circuitry, manufacturers favour the use of partially prepolymerised adhesives which are sometimes referred to as B-staged adhesives.

The present invention provides a method of realising improved bonding when using an adhesion promoter together with a polymeric or B-staged adhesive in the bonding operation.

More particularly, the invention provides a process for bonding a metal, or metal alloy, to an adhesive, by use of a functionalised adhesion promoter in conjunction with a reactive intercoat which contains functional groups capable of chemically reacting with both the functionalised adhesion promoter and the adhesive.

Using the process of the present invention, an improvement of adhesion is achieved when using a polymeric or B-staged adhesive, such an improvement being shown by measurements of 90° peel strength and lap-shear strength on the final composite material.

The metal or metal alloy may be in strip, sheet, wire, powder or massive form. The metal is preferably copper, cobalt, zinc, nickel, silver or cadmium. It is especially preferred that the metal is in the form of copper foil.

Suitable adhesion promoters are listed in the aforementioned US Patent 3837964. The adhesion promoters are compounds which contain a ligand group and a group which is functionalised for compatibility with the adhesive.

Groups functionalised for compatibility with the adhesive include, for example, amino, polyalkyleneimino, acylamido, hydroxy, (meth) acryloylamido, carboxy, carbonamido, ureido, thiol, 1,2-epoxy, halogeno, and carboxylic ester groups. The adhesion promoter may contain several different types of functionalised group.

An adhesion promoter which can be used in the process of the present invention is a compound containing a ligand group and a group of the formula:

$-NRCO(R^1)_a X_b CR^2 = CH_2$

wherein:

R is a hydrogen atom or a monovalent hydrocarbyl or substituted hydrocarbyl group;

$R^1$ is a divalent hydrocarbyl or substituted hydrocarbyl group;

$R^2$ is a hydrogen atom or an alkyl group;

X is a divalent group -NRO-or -NRCO-;

a is zero or one; and

b is zero or one.

The ligand group preferably contains at least two hetero-atoms, by which is meant an atom other than carbon or hydrogen. The hetero-atom can be, for example, a nitrogen, sulphur or oxygen atom. Many suitable ligand groups contain at least one of the hetero-atoms in a ring system. The ligand group may be a triazole, an imidazole, an indazole, a thiazole, an oxazole, a xanthate or a phthalazine group or a derivative thereof. Derivatives of the ligand group include benzotriazole, naphthotriazole, benzimidazole, naphthimidazole, 2-mercaptothiazole, 2-mercaptobenzothiazole, 2-mercaptobenzimidazole, and 2-mercaptobenzoxazole.

For convenience hereafter, the group of the formula $-NRCOR^1_aX_bCR^2=CH_2$ will be referred to as the "unsaturated amido group". It will be appreciated that the unsaturated amido group is separated from the ligand group and together the two groups form the compound which is the adhesion promoter. The unsaturated amido group may be bonded to one of the hetero-atoms of the ligand group, but is preferably bonded to a carbon atom of the ligand group. Preferred compounds for use in the process of the present invention are those in which the ligand group is a part of a fused ring system, for example as in benzotriazole, and the unsaturated amido group is bonded to one of the carbon atoms of the benzo group, for example as in a 5-substituted benzotriazole or a 4-substituted naphthotriazole.

In the unsaturated amido group, the group R attached to the nitrogen atom is preferably hydrogen but may be a lower alkyl group, that is an alkyl group containing 1 to 4 carbon atoms, particularly a methyl group. The group $R^1$ is typically an alkylene group, particularly a straight chain alkylene group, Thus, the group $R^1$ can be a group of the type $-(CH_2)_n-$ where n is an integer. The value of n is typically at least 2, and particularly is at least 4. In general, no particular benefit is gained if the value of n is in excess of 30 and generally satisfactory compounds are those in which the value of n does not exceed 20. In the group X, the group R is typically a hydrogen atom but may be a lower alkyl group. It is preferred that a and b are both zero or are both one. The group $R^2$ is conveniently a hydrogen atom but may be a lower alkyl group such as a methyl group.

In one class of compound for use in the process of the present invention, the ligand group is benzotriazole and the unsaturated amido group is in the 5 position. A preferred compound of this type is one in which R is a hydrogen atom, a and b are both one, $R^1$ is a tetramethylene, pentamethylene or undecamethylene group, X is -NHCO-, and $R^2$ is a hydrogen atom or a methyl group, such as, for example 5-[6'-(methacryloylamino)hexanoylamino]benzotriazole. Alternatively the ligand group may be benzothiazole as in, for example 6-[6'-(methacryloylamino)hexanoylamino]-2-mercaptobenzthiazole.

The reactive intercoat, hereafter referred to as the "primer", is so formulated to contain at least one reactive group which is capable of reacting with the adhesion promoter and the adhesive. The primer preferably contains several reactive groups which are capable of reacting with the adhesion promoter and the adhesive. Compounds which can be used as the primer include (multi)functional relatively low molecular weight, preferably less than 5000, polymeric acrylates, methacrylates, isocyanates, "blocked" isocyanates, oxiranes, esters, polyesters, imides, polyimides, anhydrides, glycidyl-esters, glycidyl (meth) acrylates, glycidyl alcohols, polyols, polyamines, and polyamides. A particularly suitable primer is, or contains, triethyleneglycoldimethacrylate.

The primer is usually used as a solution in an organic solvent, for example a dialkylketone. Solution strengths of the primer may vary from 0.01% w/v up to 100% w/v, but will be preferably in the range 2 to 200% w/v.

When the primer contains (meth)acrylate functionality, a curing agent is preferably used, especially incorporated in a solution containing the primer. Curing agents may be selected from any available radical initiator. Suitable initiators are commercial peroxides such as diacyl peroxides, peroxydicarbonates, diperoxyketals and dialkylperoxides. Dibenzoyl peroxide and t-butyl benzoate are preferred curing agents.

The adhesive is a polymeric adhesive or a partially pre-polymerised adhesive. In particular, the adhesive is an acrylic adhesive. Using a partially pre-polymerised adhesive, curing of this is effected after the adhesive has been coated onto the metal surface. The adhesive is preferably coated onto a metal surface which has been pre-coated with the adhesion promoter and the primer.

The process of the present invention is conveniently effected by pre-coating a metal surface with the adhesion promoter and then with the primer, or pre-coating with a mixture containing the adhesion promoter and the primer, then coating the adhesive onto the pre-coated surface and curing the coating.

The coating of the metal surface with an adhesion promoter may be effected by applying the adhesion promoter alone to the surface of the metal. However, it is generally preferred that coating is effected by applying the adhesion promoter in a suitable medium to the metal surface. More specifically, the adhesion promoter can be applied to the metal surface in the form of a solution in a suitable organic solvent, or as an

3

aqueous emulsion of the adhesion promoter, or as an aqueous emulsion of a solution of the adhesion promoter in a suitable organic solvent. The coating of the metal surface with the adhesion promoter may be effected before the application of the primer. Alternatively, the adhesion promoter may be applied to the metal surface in a mixture which includes the primer.

Conventional organic solvents may be used for the adhesion promoter, or mixtures thereof with the primer, and include for example alcohols, ethers, ketones and mixtures of these with aliphatic or aromatic hydrocarbons or with amides such as N,N-dimethylformamide. Especially preferred solvents are those having good wetting and drying properties and include for example ethanol, isopropanol and methylethylketone.

Aqueous emulsions of the adhesion promoter may be formed in conventional manner using conventional dispersants and surfactants, including non-ionic dispersants. It may be convenient to contact the metal surface with an aqueous emulsion of the adhesion promoter.

If the adhesion promoter is coated onto the metal surface before applying the primer, the process of coating with the adhesion promoter may be repeated, if desired several times, before applying the primer. However, a single coating step gives generally useful results and hence the use of a single coating step is generally preferred.

The adhesion promoter and primer may be applied to the metal surface using known application methods which include bead, gravure, reverse roller coating, air knife coating, doctor blade coating, dipping, painting and spraying.

The metal surface is preferably treated with the adhesion promoter and is then overcoated with a dilute solution or suspension of the primer, this solution or suspension also containing a curing agent. After drying, a thin composite coat is obtained and this is optionally cured, by irradiation or heat, prior to completing the process by coating with an adhesive. An alternative process is to coat the metal or metal oxide surface with a solution or suspension which contains the adhesion promoter, the primer and the curing agent prior to coating with the adhesive.

Coating with the adhesion promoter and the primer is typically effected at a temperature in the range from 0 up to 80°C. The adhesion promoter is conveniently applied as a solution containing from 0.01 up to 20% w/v of the adhesion promoter. The primer is also conveniently applied as a solution and the solution preferably contains from 2 up to 20% w/v of the primer. The amount of curing agent is dependent on the nature of both the primer and the curing agent and is typically used in an amount of from 0.005 up to 5% w/w of curing agent relative to the primer.

The adhesive is a polymeric adhesive or a partially pre-polymerised adhesive. The adhesive is a solid at normal temperature (that is from about 10°C up to about 30°C). The adhesive is soluble in at least some of the organic solvents which can be used as solvents for the adhesive promoter and the primer. However, the adhesive may be applied to the pre-coated metal surface as a solid and then heated, optionally under an applied pressure, to an elevated temperature which is at least 100°C. The adhesive may be applied as a particulate solid to the pre-coated metal surface but is very conveniently applied as a sheet, which is typically of thickness of from 0.01 up to 1mm. The process used to bond the solid adhesive to the pre-coated metal surface will be dependent on the type of adhesive used. Using a partially pre-polymerised acrylic adhesive, heating is effected at a temperature of at least 100°C, and in many cases at least 150°C, and an applied pressure of at least $0.1 MNm^{-2}$ for example in the range from $0.1 MNm^{-2}$ up to $50 MNm^{-2}$, particularly from $1 MNm^{-2}$ up to $10 MNm^{-2}$.

As a particular aspect of the present invention, the adhesive is a partially pre-polymerised acrylic adhesive; the adhesion promoter contains a ligand group to which is bonded an acrylic or methacrylic group and the primer contains at least one acrylate or methacrylate group.

The process of the present invention may be used for the production of a composite article having a metal to polymer bond or may be used for the production of articles wherein a metal is bonded to the same or a different metal using an adhesive.

The process of the present invention to produce a composite article having a metal to polymer bond may be used in the primary production of printed circuit boards (single, double sided or flexible boards) and elaboration of circuit boards (multilayer board fabrication, solder masks, photoresists and covercoats).

The process of the present invention is illustrated by the following non-limiting example.

Example

Electrolytic copper foil having one dendritic face was degreased with acetone. (It is essential that the foil used at this stage should have no corrosion inhibition treatments). The degreased foil was immersed in an ethanolic solution of 5-(6'-methacryloylamino)hexanoyl aminobenzotriazole (0.5% w/v) for 5 minutes at 60°C. The foil was then removed from the bath, washed with ethanol and dried. A solution of triethyleneglycol dimethacrylate (4% w/v) in methylethylketone containing a small amount (0.004% w/v) of t-butylperbenzoate, was coated on to the pre-coated dendritic face of the foil. After drying, a laminate was prepared consisting of an inert polymeric substrate (such as epoxy glass fibre board); a B-staged acrylic adhesive in the form of a thin sheet; and the treated copper foil, the coated dendritic face of which was in contact with the adhesive. The resulting composite structure structure was heated at 170°C for 45 minutes under a pressure of 2.1MNm$^{-2}$ (300 psi) to effect curing of the adhesive. Subsequent peel tests (as defined in UK Air Ministry Specification D.T.D. 5577) produced the following results:-

| Copper pretreatment | 90° peel strength |
|---|---|
| None (control) | 0.91 KNm$^{-1}$ |
| Adhesion promoter alone (comparative) | 0.61 KNm$^{-1}$ |
| Triethyleneglycoldimethacrylate/ t-butylperbenzoate (comparative) | 0.68 KNm$^{-1}$ |
| Adhesion promoter followed by triethyleneglycoldimethacrylate/ t-butylperbenzoate (Example) | 1.75 KNm$^{-1}$ |

**Claims**

1. A process for bonding a metal, or metal alloy, to an.adhesive by the use of a functionalised adhesion promoter in conjunction with a reactive intercoat which contains functional groups capable of chemically reacting with both the functionalised adhesion promoter and the adhesive.

2. A process as claimed in claim 1 wherein a metal surface is either
A(i) coated with the functionalised adhesion promoter and then with the reactive intercoat; or
A(ii) coated with a mixture of the functionalised adhesion promoter and the reactive intercoat; and
B the adhesive is then applied to the pre-coated metal surface.

3. A process as claimed in either claim 1 or claim 2 wherein the metal is copper.

4. A process as claimed in any one of claim 1 to 3 wherein the adhesion promoter contains a ligand group and a group which is functionalised for compatibility with the adhesive.

5. A process as claimed in claim 4 wherein the adhesion promoter is a compound containing a ligand group and a group of the formula
$-NRCO(R^1)_aX_bCR^2 = CH_2$
wherein:
R is a hydrogen atom or a monovalent hydrocarbyl or substituted hydrocarbyl group;
$R^1$ is a divalent hydrocarbyl or substituted hydrocarbyl group;
$R^2$ is a hydrogen atom or an alkyl group;
X is a divalent group - NRO-or -NRCO-;
a is zero or one; and
b is zero or one.

6. A process as claimed in any one of claims 1 to 5 wherein the reactive intercoat is a low molecular weight polymeric acrylate, methacrylate, isocyanate, or blocked isocyanate; an oxirane; an ester; a polyester; an imide; a polyimide; an anhydride; a glycidyl ester; a glycidyl (meth)acrylate; a glycidyl alcohol; a polyol; a polyamine or a polyamide.

7. A process as claimed in any one of claims 1 to 6 wherein the reactive intercoat contains a (meth)-acrylate functionality and a curing agent is also used.

8. A process as claimed in any one of claims 1 to 7 wherein the adhesive is a polymeric adhesive or a partially pre-polymerised adhesive.

9. A process as claimed in claim 8 wherein the adhesive is an acrylic adhesive.

10. A process as claimed in any one of claims 1 to 9 wherein the adhesive is a partially pre-polymerised acrylic adhesive, the adhesion promoter contains a ligand group to which is bonded an acrylic or methacrylic group and the reactive intercoat contains at least one acrylate or methacrylate group.